# EUROPEAN PATENT APPLICATION

(11) **EP 3 407 487 A1**
(43) Date of publication of application: **28.11.2018**
(21) Application number: 18171278.7
(22) Date of filing: 08.05.2018
(51) Int. Cl.: H03F 1/22, H03F 1/02

(54) **HIGH LINEARITY SIGNAL AMPLIFIER**

(30) Priority: 22.05.2017 PT 2017110087
(71) Applicant: Instituto Politécnico De Leiria, 2411-901 Leiria (PT)
(72) Inventor: FERREIRA MIRANDA, Nuno Miguel, 410-338 Leira (PT); MOREIRA MENDES, Luís Miguel, 2415-474 Leira (PT)
(74) Representative: do Nascimento Gomes, Rui

(57) **Abstract**

This invention falls within the technical scope of signal amplifiers, more particularly a high linearity signal amplifier.

It is thus the object of this invention a high linearity signal amplifier (1) comprising a gain stage, which in its turn comprises a transconductance block (7) and an active load (8) connected to the transconductance block (7). The object of the present invention, comprising these two elements, provides high linearity, stability and simplicity, without the need to use negative feedback loops. In terms of performance, this approach presents a major advantage which is that, in the absence of feedback, the gain stage circuit of the signal amplifier (1) is intrinsically stable and can have a high bandwidth.

## Description

### FIELD OF THE INVENTION

This invention falls within the technical scope of signal amplifiers, more particularly a high linearity signal amplifier.

### BACKGROUND OF THE INVENTION

The classification of signal amplifiers is extremely complex due to the wide range of characteristics that can be considered in this classification. Some examples are:
a) signal amplifiers may be discrete (exclusive use of discrete components), hybrid (include monolithic and discrete parts) and integrated;
b) the signal amplifiers can be voltage amplifiers, current amplifiers, transimpedance amplifiers and transadmittance amplifiers;
c) signal amplifiers can be classified according to the type of application in which they are used, for example, radio frequency amplifiers, instrumentation amplifiers and audio amplifiers;
d) the signal amplifiers may be narrow-band or wide-band amplifiers, with or without feedback;
e) the signal amplifiers may be of low noise, maximum gain and/or power amplifiers;
f) signal amplifiers may be classified according to the type of active components they use, for example field-effect transistors, junction transistors or thermionic valves.

Amplifiers are electronic circuits used worldwide, primarily due to their main function which is to raise the level of the input signal while maintaining the signal integrity or information content and low noise level.

In the characterization of an amplifier, not only the performance aspects (for example, input and output impedance, gain, bandwidth, noise, linearity, stability, efficiency and consumption) must be taken into account, but also the architecture itself of the circuit.

Reducing the complexity of an amplifier circuit can have direct beneficial implications in reducing the final cost of the equipment. In addition, the complexity of an amplifier circuit is extremely important from an industrial point of view, since it can cause the industrialization, manufacture and commercialization of a product to be infeasible, even when the prototype presents excellent electrical and electronic performance.

As stated above, the present invention discloses a new amplifier circuit of reduced complexity, but at the same time ensuring a good performance in terms of linearity and stability.

Signal amplifiers can be divided into several sub-circuits or blocks, as shown in the diagram of 1-Signal Amplifier*; 2-Input Circuit; 3-Output Circuit; 4-Gain Stage; 5-Input Terminal; 6-Output Terminal*

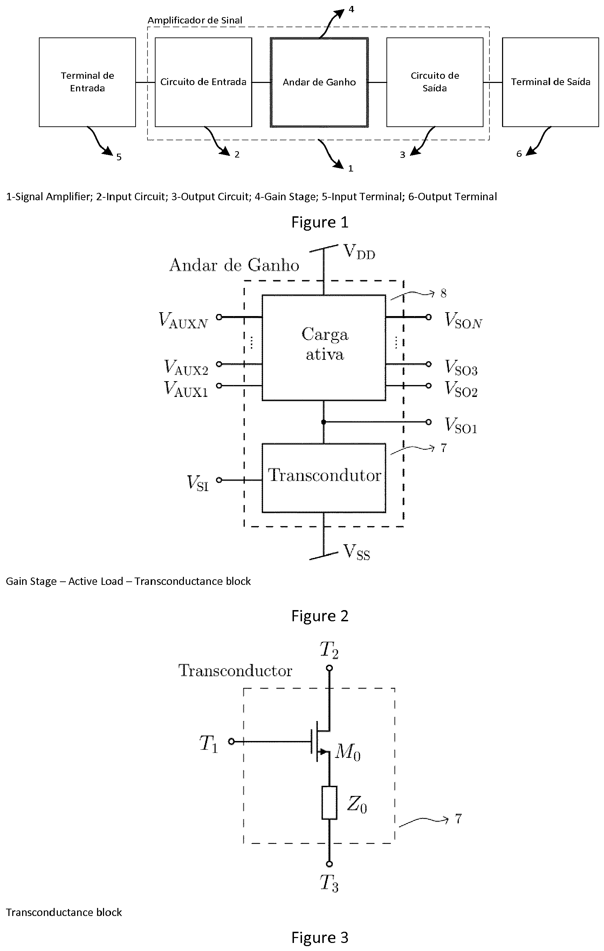

*Figure 1*, containing a general configuration of a signal amplifier as known according to the state of the art. It should be noted that the structure of a signal amplifier is not limited to the block diagram shown in figure 1. The latter is presented in order to provide a clear view of the generic structure of a signal amplifier.

Each constituent block of the signal amplifier (block 1 of 1-Signal Amplifier; *2-Input Circuit; 3-Output Circuit; 4-Gain Stage; 5-Input Terminal; 6-Output Terminal*
*Figure 1*) has specific functions related to the performance of the amplifier. In 1-Signal Amplifier*; 2-Input Circuit; 3-Output Circuit; 4-Gain Stage; 5-Input Terminal; 6-Output Terminal*
*Figure 1* the input terminal (block 5) defines the input port of the amplifier, the output terminal (block 6) specifies the output port of the amplifier and the gain stage (block 4) is the circuit consisting of the components that allow the amplifier to have gain.

The signal amplifier (block 1) in the most general view of this type of electronic circuit (1-Signal Amplifier; *2-Input Circuit; 3-Output Circuit; 4-Gain Stage; 5-Input Terminal; 6-Output Terminal*
*Figure 1*) is comprised of the input circuit (block 2), the gain stage (block 4) and the output circuit (block 3). The input circuit (block 2) and the output circuit (block 3) may have a number of functions, among which the following are herein highlighted: impedance adaptation, gain stage polarization, amplifier stabilization, signal monitoring, control and adjustment of the amplifier gain, coupling or decoupling of electrical quantities (DC) from the amplifier relatively to the circuits or equipment upstream and downstream of the signal amplifier.

This list is not intended to be exhaustive and therefore it is merely indicative of the type of functions that the input and output circuits may have.

The gain stage (block 4 of Figure 1) of an amplifier as known in the state of the art can be very simple (few elements) or of high complexity (many elements) and it may or may not have internal feedback. Usually, when the gain stage circuit has internal feedback, the internal gain is also high (it can be achieved using, for example, operational amplifiers). The complexity of the amplifier gain stage circuit can usually condition the operating frequency range. At high operating frequencies (over a few hundred MHz) the use of simple circuits for the gain stage is the common practice.

In its simplest form, state-of-the-art gain stages (block 4 of Figure 1) use transistors connected at common gate or source, or at common base or emitter, depending on the technology of the active element(s). The simplicity of these circuits allows for enhancing, for example, the maximum operating frequency and the dynamic performance of the amplifier. Due to the dependence of the transconductance from the active element with the operating point, these are non-linear circuits, thus introducing distortion in the signal. In addition, because the transconductance also depends on temperature, the performance of these circuits is conditioned by the circuit's own functioning (variation of internal temperature of operation of the components) as well as by external factors. Another consequent limitation of the simplicity of such circuits is the difficulty of obtaining a complex transfer function. Common gate or source, or common base or emitter configurations are generally used in radio frequency amplifiers due to their unavoidable need to operate at high frequencies.

In the high fidelity audio consumption sector, the use of very simple, non-feedback circuits in the gain stage (block 4 of Figure 1) of the amplifiers is usual. These audio amplifiers commonly use thermionic valves as active elements. Many audiophiles have a preference for this technology because of the softer sonority provided by thermionic valves comparatively to solid-state technologies.

Audio amplifiers employing thermionic valves are, from the standpoint of topology, extremely simple and use very few components, either active or passive. In this technology it is possible to obtain an acceptable level of distortion (less than 0.5%) due to the low transconductance values of the thermionic devices, as well as to the use of only a small fraction of the entire available voltage range.

In general, the transfer characteristic of amplifier circuits can be quite linear if negative feedback is used internally at the gain stage. Such amplifiers are usually composed of high gain circuits (e.g. operational amplifiers) associated with one (or more) passive element(s) which constitute(s) a negative feedback loop. The feedback loop strongly contributes to the definition of the transfer function of the global circuit.

The linearity and the high rejection factor of noise and interference from the feeds are some of the main positive impacts of the negative feedback on the performance of the amplifiers. Despite these advantages, the feedback technique also has some drawbacks, thus causing a negative impact on some of the performance parameters of the amplifiers, namely, response speed, maximum operating frequency and stability. In effect, stability is not guaranteed in this type of amplifiers, motivating, in most cases, the application of compensation techniques. These techniques usually ensure the circuits stability but compromise other important characteristics as regards the performance of the amplifiers (e.g., maximum operating frequency).

Due to the factors which are inherent to the feedback techniques mentioned above, the feedback amplifiers are usually comprised of a large number of elements, not only the amplification active components but also the elements required for the feedback loop and compensation elements, thus making the circuits complex.

### SUMMARY OF THE INVENTION

It is thus the object of this invention a high linearity signal amplifier (1) comprising a gain stage, which in its turn comprises a transconductance block (7) and an active load (8) connected to the transconductance block (7). The object of the present invention, comprising these two blocks, provides high linearity, stability and simplicity, without the need to use negative feedback loops. In terms of performance, this approach presents a major advantage which is that, in the absence of feedback, the gain stage circuit of the signal amplifier (1) is intrinsically stable and can have a high bandwidth.

In an advantageous mode of the amplifier (1) of this invention, the transconductance block (7) comprises a first terminal (V_{SI}) connected to a first input of the gain stage and a second terminal (V_{SO1}) connected to a first output of the gain stage and the active load (8) is connected to the first output of the gain stage and comprises at least one active load element (9) with an auxiliary input terminal of the gain stage that is suitable for polarization, processing or control. This enables a highly simplified configuration, wherein the amplifier (1) has a main input, a main output and at least one auxiliary input suitable for polarization, processing or control by each active load element (9) comprised of the active load (8).

In a configuration of the amplifier (1) of this invention, which is combinable with any of the foregoing, both the transconductance block (7) and each active load element (9) comprises a transistor, all of the transistors having the same characteristics. The linearity of the amplifier (1) of this invention is strongly conditioned by the relationship between the transistor characteristics of the transconductance block (7) and the transistors of the active load elements (9). In the case of the operating point of all active elements - the transistors - being the same, the linearity of the circuit is maximized.

In another advantageous embodiment of the object of this invention, combinable with any of the foregoing, the active load (8) is telescopic, comprising a plurality of active load elements (9), each one comprising an auxiliary output terminal of the gain stage. As previously mentioned, the active load (8) quite efficiently counteracts the non-linearities generated in the transconductance block (7) and, on the other hand, allows for an increase of the output signal excursion. When the active load (8) consists of N load elements, this enables N auxiliary inputs and N-1 auxiliary outputs of the amplifier block. Having multiple inputs and multiple outputs, this configuration allows the implementation of complex transfer functions in the gain stage, enabling the amplification circuit to process analog signals in different ways.

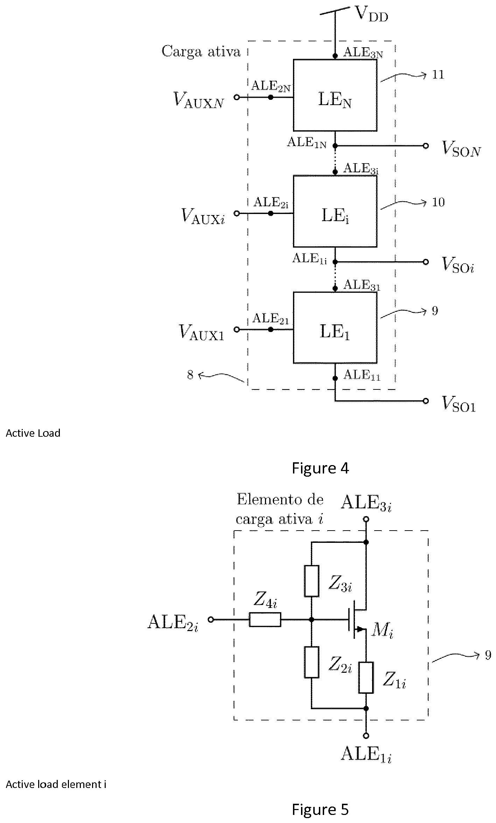

With reference to the embodiment shown in figure 4, the active load (8) can be comprised of several load elements connected according to the diagram of the representation of Figure 4.

In another advantageous embodiment of the object of this invention, specifically related to the case where the active load (8) is telescopic, it comprises a plurality of active load elements (9) with first, second and third terminal, wherein the second terminal consists of a distinct auxiliary input of the amplifier, and in which:
a. a first active load element (9) has the first terminal connected to the first output of the amplifier,
b. any active load element (9) other than the last one, has the third terminal connected to an auxiliary output of the amplifier;
c. one last active load element (9) with the third terminal connected to a power supply of the amplifier.

It is a configuration of the amplifier (1) with a very simple telescopic active load, keeping the aforementioned functionalities.

It is also an object of the present invention to use a combination between:
a. a transconductance block (7) comprising a first terminal connected to a first input of the gain stage and a second terminal connected to a first output of the gain stage, and
b. an active load (8) connected to the first output of the gain stage and comprising at least one active load element (9) with an auxiliary input terminal of the gain stage suitable for polarization, processing or control
as gain stage for a signal amplifier (1).

### DESCRIPTION OF THE FIGURES

Figure 1 - block diagram representing a generic configuration of a signal amplifier (1) as known in the state of the art.
Figure 2 - a simplified block diagram representative of a specific embodiment of the amplifier (1) of the present invention with two main blocks: the transconductance block (7) and the active load (8). The circuit has a polarization and signal input, one or more signal outputs, each one providing a gain different from that of the other outputs, and may have several auxiliary inputs that can be used for polarization, processing or control. There are two more inputs, which are intended for powering the entire gain stage.
   The transconductance block (7) (block 7 of Figure 2) is quite simple, as discussed above. It is comprised of a transistor and impedance connected according to the scheme shown in Figure 3. The impedance Zo can take any value (real or complex), including zero. Although in Figure 3 the transistor is a MOSFET, it may be of another type.
Figure 3 - Schematic representation of a transconductance block (7) suitable for configuring the amplifier (1) of this invention, comprising three terminals T₁, T₂ and T₃ respectively connected to the port, drain and source of a MOSFET transistor M₀, in particular an impedance Z0 between the terminal T₃ and the source of said MOSFET. Although in the representation of Figure 3 a MOSFET has been used, the transistor of the transconductance block (7) can be of another type.
Figure 4 - Schematic representation of a telescopic active load (8) suitable for configuring the amplifier (1) of the present invention, comprising N active load elements (9) (LE₁-LE_{N}) (block 9), N inputs (V_{AUX1} - V_{AUXN}) and N outputs (V_{SO1} - V_{SON}), in addition to the power input V_{DD}.
Figure 5 - Schematic representation of an active load element (9) from an active load (8) suitable for configuring the amplifier (1) of the present invention, consisting of several passive components and one active component (transistor). Generally, and considering only the load element i (LEᵢ), where i can take any value between 1 and N, the passive components (resistors, capacitors and inductances) of the load element i can be grouped into the 4 impedances (Z₁ᵢ, Z₂ᵢ, Z₃ᵢ, and Z₄ᵢ). These impedances (complex values) can take any value. This active load element (9) comprises the first (ALE₁ᵢ), second (ALE₂ᵢ) and third (ALE₃ᵢ) terminals, further comprising:
   - an impedance Z₁ᵢ between the source of the transistor and the first terminal,
   - an impedance Z₂ᵢ between the transistor port and the first terminal,
   - an impedance Z₄ᵢ between the transistor port and the second terminal and
   - an impedance Z₃ᵢ between the transistor's port and drain, which in its turn is directly connected to a third terminal.
   Although in Figure 5 the transistor is a MOSFET, it may be of another type.

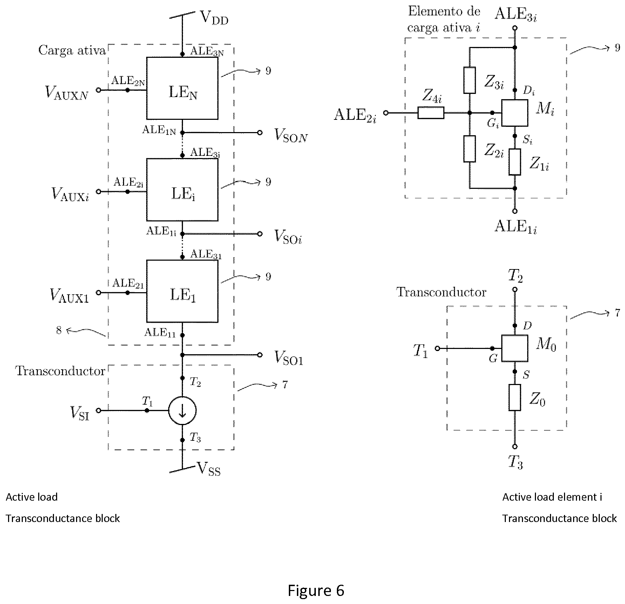

Figure 6 - Schematic representation of an embodiment of the gain stage block of an amplifier (1) according to the present invention.

### DETAILED DESCRIPTION OF THE INVENTION

The more general advantageous configurations of the present invention are described in the Summary of the invention. These configurations are detailed below in accordance with other advantageous and/or preferred embodiments of this invention.

In a preferred embodiment of the amplifier (1) of the present invention, combinable with any of those previously described, the transconductance block (7):
c. further comprises an impedance element connected to the transistor source or emitter comprised of the transconductance block (7), preferably with non-zero impedance, which is connected to a third terminal of the transconductance block (7), connected to a zero or negative supply voltage (Vss),
d. the said second terminal is connected to the drain or collector of said transistor comprised of the transconductance block (7) and
e. the said first terminal being connected to the port or base of said transistor comprised of the transconductance block (7).

In another preferred embodiment of the amplifier (1) of this invention combinable with any of the foregoing, the active load (8) comprises at least one active load element (9) having first, second and third terminals, wherein:
a. the first terminal is connected to an output of the amplifier,
b. the second terminal is connected to an auxiliary input of the amplifier.

Therefore, all the active load elements (9) constituting the active load (8) have the same wiring diagram.

In another preferred embodiment of the amplifier (1) of the present invention, which is a specific case of the configuration immediately above described, each active load element (9) comprises first, second and third terminals, additionally comprising:
a. an impedance between the source or emitter of the transistor and the first terminal,
b. an impedance between the port or base of the transistor and the first terminal,
c. an impedance between the port or base of the transistor and the second terminal, and
d. an impedance between the port or base and the drain or collector of the transistor, which in its turn is directly connected to a third terminal.

In a specific embodiment according to Figure 5, the active load elements (9) are comprised of several passive components and one active component (transistor). Generally, and considering only the load element i of Figure 5, where i can take any value between 1 and N, the passive components (resistors, capacitors and inductances) of the load element i can be grouped into the 4 impedances (Z₁ᵢ, Z₂ᵢ, Z₃ᵢ, and Z₄ᵢ) shown in Figure 5. These impedances (complex values) can take any value.

In an alternate configuration of the amplifier (1) of the present invention, the active load (8) comprises a single element of active load (9) for which:
a. the first terminal is connected to a single output of the amplifier;
b. the second terminal is connected to a single auxiliary input of the amplifier;
c. the third terminal is connected to one of the terminals of the power supply of the amplifier.

In another embodiment of the amplifier (1) of the present invention any of said impedances may consist of resistors, capacitors, inductors or combinations thereof.

### EMBODIMENTS

The embodiments of the object of this present invention are hereinafter described with reference to Figures 2-6.

The gain stage of the amplifier (1) of the present invention uses a telescopic active load circuit (8) that is quite effective in counteracting the nonlinearities generated in the transconductance block (7) and, on the other hand, it allows for an increase of the output signal excursion. The active load (8) may be comprised of a load element only or of several load elements connected in accordance with the diagram of Figure 4. As can be seen, when the active load (8) is comprised of N load elements, N inputs and N outputs may exist in addition to the V_{DD} and V_{SS} power inputs. Ultimately, and for the gain stage to be operated properly, there must always be a load element (9).

All the load elements comprising the active load (8) have the same wiring diagram and are comprised of several passive components and one active component (transistor) as shown in Figure 5. Generally, and considering only the load element i, where i can take any value between 1 and N, the passive components (resistors, capacitors and inductances) of the load element i can be grouped into the 4 impedances shown in Figure 5. These impedances (complex values) can take any value.

As regards the transistor used in the load element i (Figure 5), it has the same characteristics as the transistor used in the transconductance block (block 7). This aspect is fundamental for an improved operation of the proposed gain stage because the linearity of the circuit is strongly conditioned by the relationship between the characteristics of the transconductance block (block 7) transistor and those of the load element transistors (LE₁ - LE_{N}) of the active load (block 8). In the event that all active elements are similar, the linearity of the circuit is maximized.

The topology of the gain stage and the load structure described above make the transfer function which characterizes the gain stage circuit to not have a significant dependence on any active element of the circuit, thus said function being essentially dependent on the passive elements used and the values thereof.

The input terminal V_{SI} defines the input port of the amplifier and the output terminals (V_{SO1} - V_{SON}) specify the various output ports of the amplifier, where N is an integer greater than or equal to 1. Thus, the amplifier may have only one (Vsoi) or several outputs of this type (V_{SO1} - V_{SON}).

The input terminals (V_{AUX1} - V_{AUXN}) define auxiliary polarization, processing or control inputs. These may or may not be used. Ultimately, there might not be any of these entries (V_{AUX1}).

The non-feedback telescopic active load signal amplifier is comprised of a transconductance block (block 7) and a telescopic active load (block 8) comprising N active load elements (block 9) (LE₁, ..., LEᵢ, .., LE_{N}, where 1 ≤ i ≤ N), where N is always greater than or equal to 1.

The transconductance stage (block 7) is comprised of a transistor M₀ and an impedance Z₀. This impedance (Z₀) can be simple (resistance or inductance) or can be the result of an association of several passive elements (resistors, capacitors and inductances). It should be noted that, ultimately, the impedance Z₀ can be zero.

The input terminal (T₁) of the transconductance stage (block 7), which is also the main input terminal of the signal amplifier (V_{SI}), connects directly to one of the terminals (G) of the transistor Mo. The terminal S of the transistor Mo may connect directly to the terminal T₃ of the transconductance stage or to one of the terminals of the impedance Zo. In this case, the other terminal of the impedance Zo connects to the terminal T₃, which in its turn connects to the terminal V_{SS} of the amplifier power supply. The output terminal (T₂) of the transconductance stage, which is also the terminal D of the transistor M₀, connects to the terminal V_{SO1} of the active load element 1 (LE₁). It should be noted that although a MOSFET was used, the transistor could be of another type.

The active load (block 8) of the transconductance stage (block 7) may be comprised of one active load element (LE₁) only or of several elements (LE₁, ..., LEᵢ, ..., LE_{N}, where 1 ≤ i ≤ N) in telescopic configuration, all of which are described in the scheme of block 8.

The active load element i (LEᵢ - block 9), where 1 ≤ i ≤ N, has 3 terminals, ALE₁ᵢ, ALE₂ᵢ and ALE₃ᵢ, and is formed by 4 impedances (passive elements) (Z₁ᵢ, Z₂ᵢ, Z₃ᵢ and Z₄ᵢ) and a transistor Mᵢ. Each of these impedances can be simple (resistor, capacitor or inductance) or can be the result of an association of several passive elements (resistors, capacitors and inductances). It shall be noted that, ultimately, each one of the impedances Z₁ᵢ, Z₂ᵢ, Z₃ᵢ and Z₄ᵢ can take any value. Block 9 shows that the impedance Z₁ᵢ is connected between the terminal Sᵢ-of transistor Mi and the terminal ALE₁ᵢ of the LEᵢ, Z₂ᵢ is connected between the terminal Gᵢ of the transistor Mᵢ and the terminal ALE₁ᵢ of the LEᵢ, Z₃ᵢ is connected between the terminal Gᵢ of the transistor Mᵢ and the terminal ALE₃ᵢ of the LEᵢ, and finally the Z₄ᵢ is connected between the terminal Gᵢ of the transistor Mᵢ and the terminal ALE₂ᵢ of the LEᵢ.

As previously mentioned, the active load of the amplifier (block 8) can be formed by N active load elements (LE₁, ..., LEᵢ, ..., LE_{N}), where N ≥ 1. The terminal T₂ of the transconductance block (block 7) connects directly to the terminal ALE₁₁ of the first active load element (LE₁). These terminals (T₂ and ALE₁₁) will constitute the output V_{SO1}. In its turn, the terminal ALE₂₁ of the first active load element (LE₁) connects to the auxiliary input V_{AUX1} of the amplifier. The third terminal (ALE₃₁) of the first active load element (LE₁) connects to the power supply (V_{DD}) if the active load of the amplifier is formed by an active load element only, or connects to the next active load element (LE₂) if the active load of the amplifier is formed by more than one active load element. Generally, and considering an amplifier whose active load is formed by several active load elements, the active load element i (LEᵢ) connects directly to the preceding active load element (LEᵢ₋₁) and next active load element (LEᵢ₊₁). Thus, the terminal ALE₁ᵢ connects to the ALE_{3 (i-1)} constituting the output V_{SOi}, and the terminal ALE₃ᵢ connects to the terminal ALE_{1 (i+1)} if the active load element i is not the last one or, if it is the last one, it will connect to one of the power supply terminals (V_{DD}). The terminal ALE₂ᵢ connects to the V_{AUXi}.

The person skilled in the art will understand the present invention as not limited to the embodiments described herein, a number of changes being possible within the scope of the invention.

## Claims

1. A high linearity signal amplifier (1) **characterized in that** it comprises a gain stage, in its turn comprising a transconductance block (7) and an active load (8) connected to the transconductance block (7).

2. An amplifier (1) according to the previous claim, **characterized in that:**
a. the transconductance block (7) comprises a first terminal connected to a first input of the gain stage and a second terminal connected to a first output of the gain stage and
b. the active load (8) is connected to the first output of the gain stage and comprises at least one active load element (9) with an auxiliary input terminal of the gain stage that is suitable for polarization, processing or control.

3. An amplifier (1) according to any of the previous claims **characterized in that** both the transconductance block (7) and each of the active load elements comprise a transistor, all transistors having the same characteristics.

4. An amplifier (1) according to any of the previous claims **characterized in that** the transconductance block (7):
a. further comprises an impedance element connected to the transistor source or emitter comprised of the transconductance block (7), preferably with non-zero impedance, which is connected to a third terminal of the transconductance block (7), connected to V_{SS},
b. the said second terminal is connected to the drain or collector of said transistor comprised of the transconductance block (7) and
c. the said first terminal being connected to the port or base of said transistor comprised of the transconductance block (7)

5. An amplifier (1) according to any of the previous claims **characterized in that** the active load (8) comprises at least one active load element (9) having first, second and third terminals, wherein:
a. the first terminal is connected to an output of the amplifier,
b. the second terminal is connected to an auxiliary input of the amplifier.

6. An amplifier (1) according to the previous claim **characterized in that** each active load element (9) comprises first, second and third terminals, additionally comprising:
a. an impedance between the source or emitter of the transistor and the first terminal,
b. an impedance between the port or base of the transistor and the first terminal,
c. an impedance between the port or base of the transistor and the second terminal, and
d. an impedance between the port or base and the drain or collector of the transistor, which in its turn is directly connected to a third terminal.

7. An amplifier (1) according to any of the previous claims **characterized in that** the active load (8) is telescopic, comprising a plurality of active load elements (9), each one comprising an auxiliary output terminal and an auxiliary input terminal.

8. An amplifier (1) according to the previous claim **characterized in that** the active load (8) comprises a plurality of active load elements (9) with first, second and third terminal, wherein the second terminal consists of a distinct auxiliary input of the amplifier, and in which:
a. a first active load element (9) has the first terminal connected to the first output of the amplifier,
b. any active load element (9) other than the last one, has the third terminal connected to an auxiliary output of the amplifier;
c. one last active load element (9) with the third terminal connected to one of the terminals on the power supply of the amplifier.

9. An amplifier (1) according to any of the claims 1-7 **characterized in that** the active load (8) comprises one single active load element (9) for which:
a. the first terminal is connected to a single output of the amplifier;
b. the second terminal is connected to a single auxiliary input of the amplifier;
c. the third terminal is connected to one of the terminals on the power supply of the amplifier.

10. An amplifier (1) according to any of the previous claims, **characterized in that** any of the said impedances consist of resistors, capacitors, inductors or combinations thereof.
